# EUROPEAN PATENT APPLICATION

(11) **EP 2 600 417 A1**
(43) Date of publication of application: **05.06.2013**
(21) Application number: 11812354.6
(22) Date of filing: 21.07.2011
(51) Int. Cl.: H01L 31/042, C08L 75/06, C08L 75/08

(54) **SOLAR BATTERY MODULE AND METHOD FOR PRODUCING SAME**

(30) Priority: 29.07.2010 JP 2010170918
(71) Applicant: Dexerials Corporation, Tokyo 141-0032 (JP)
(72) Inventor: NISHIMOTO Masahiro, Kanuma-shi Tochigi 322-8502 (JP); UCHIMI Toshiharu, Kanuma-shi Tochigi 322-8502 (JP)
(74) Representative: Müller-Boré & Partner Patentanwälte
(86) International application number: PCT/JP2011/066519
(87) International publication number: WO 2012/014763

(57) **Abstract**

Disclosed is a solar cell module in which a reduction in the adhesive strength of the sealing resin used is suppressed even after use in a severe environment for a long period of time, in which corrosion of an electrode is prevented, and which has favorable flame resistance. The solar cell module uses, as the sealing resin, a blended polymer of a thermoplastic ester polyol polyurethane resin including an ester-based polyol unit and a thermoplastic ether polyol polyurethane resin including an ether-based polyol unit. The blending mass ratio of the thermoplastic ester polyol polyurethane resin to the thermoplastic ether polyol polyurethane resin in the blended polymer is 10:90 to 50:50. The thermoplastic ether polyol polyurethane resin includes a polyurethane resin A having flame resistance and a polyurethane resin B having lower flame resistance but higher adhesion properties than the polyurethane resin A.

## Description

### Technical Field of the Invention

The present invention relates to a solar cell module and to a method of producing the same.

### Background Art

There is proposed a solar cell module in which sealing adhesive sheets are disposed on opposite sides of a solar battery cell with a lead wire pre-pasted to a surface electrode on the light-receiving surface of the solar battery cell, and this solar battery cell is sandwiched between a glass substrate and a protective sheet (i.e., a back sheet) and subjected to vacuum lamination treatment (Patent Literature 1). Sheets prepared by adding a cross-linking agent, an ultraviolet absorber, etc. to an ethylene vinyl acetate resin (EVA resin) that has excellent sealing properties, transparency, flexibility, adhesion properties, tensile strength, and weather resistance are widely used for the sealing resin sheets used in such a solar cell module.

### Citation List

### Patent Literature

Patent Literature 1: Japanese Patent Application Laid-Open No. 2004-311571

### Summary of the Invention

### Problems to be solved by the Invention

A solar cell module is used for a long period of time in a severe outdoor environment while exposed to sunlight, wind, and rain. Therefore, water vapor may be allowed to pass through the sealing resin, and a reduction in the adhesive strength of the sealing resin may cause a small amount of water to enter the inside of the module from a protective sheet side. In these cases, part of the ethylene vinyl acetate resin is hydrolyzed to generate an acid, and the generated acid corrodes electrodes of the solar cell module. This results in a problem in that the performance of the solar cell module deteriorates. Since the EVA resin is an easily inflammable resin, the sealing resin used for a solar cell module is required to have high flame resistance.

The present invention has been made to solve the foregoing conventional problem, and it is an object to provide a solar cell module which is, of course, excellent in not only sealing properties but also water vapor permeation resistance, in which a reduction in the adhesive strength of the sealing resin used is suppressed even after long-term use in a severe environment in which the solar cell module is exposed to sunlight, wind, and rain, in which corrosion of the electrodes is prevented, and which has high flame resistance.

### Means for Solving the Problems

The present inventors have searched for a resin that is alternative to the EVA resin conventionally used as the sealing resin for a solar cell module, favorable high sealing properties, adhesive strength, and water vapor permeation resistance, resists hydrolysis, and has flame resistance. As a results of the search, the inventors have found that: (a) a blended polymer of a thermoplastic ester polyol polyurethane resin including an ester-based polyol unit and having relatively high adhesive strength and relatively high hydrolyzability and a thermoplastic ether polyol polyurethane resin including an ether-based polyol unit and having relatively low adhesive strength and relatively low hydrolyzability has characteristics strongly reflecting the desirable characteristics of these resins (i.e., high sealing properties, adhesion properties, and hydrolysis resistance) but is reduced in their undesirable characteristics; and (b) the object of the invention can be achieved by using such a blended polymer as the sealing resin of the solar cell module, provided that the thermoplastic ether polyol polyurethane resin used together with the thermoplastic ester polyol polyurethane resin comprises two types of specific polyurethane resins, i.e., a thermoplastic polyether polyol polyurethane resin having relatively high flame resistance and a thermoplastic ether polyol polyurethane resin having relatively high adhesive strength. Thus, the present invention has been completed.

Accordingly, the present invention provides a solar cell module comprising a module substrate, a first sealing resin layer, a solar battery cell with a tab wire connected thereto, a second sealing resin layer, and a protective sheet that are stacked one on top of another, wherein
the first sealing resin layer and/or the second sealing resin layer are/is formed of a blended polymer of a thermoplastic ester polyol polyurethane resin including an ester-based polyol unit and a thermoplastic ether polyol polyurethane resin including an ether-based polyol unit,
a blending mass ratio of the thermoplastic ester polyol polyurethane resin to the thermoplastic ether polyol polyurethane resin in the blended polymer is 10:90 to 50:50, and
the thermoplastic ether polyol polyurethane resin includes a polyurethane resin A having flame resistance and a polyurethane resin B having lower flame resistance and higher adhesion properties than the polyurethane resin A.

The present invention also provides a method of producing a solar cell module, the method comprising: placing a stacked body in a vacuum laminator, the stacked body being prepared by stacking a module substrate, a first sealing resin sheet, a solar battery cell with a tab wire connected or temporarily pasted thereto, a second sealing resin sheet, and a protective sheet; and subjecting the stacked body to vacuum lamination treatment to integrate the stacked body at a time, wherein
a sealing resin sheet formed of a blended polymer of a thermoplastic ester polyol polyurethane resin including an ester-based polyol unit and a thermoplastic ether polyol polyurethane resin including an ether-based polyol unit is used as the first sealing resin sheet and/or the second sealing resin sheet, a blending mass ratio of the thermoplastic ester polyol polyurethane resin to the thermoplastic ether polyol polyurethane resin in the blended polymer is 10:90 to 50:50, and the thermoplastic ether polyol polyurethane resin includes a polyurethane resin A having flame resistance and a polyurethane resin B having lower flame resistance and higher adhesion properties than the polyurethane resin A.

The present invention also provides a sealing resin sheet for a solar cell module, the sealing resin sheet formed of a blended polymer of a thermoplastic ester polyol polyurethane resin including an ester-based polyol unit and a thermoplastic ether polyol polyurethane resin including an ether-based polyol unit, wherein
a blending mass ratio of the thermoplastic ester polyol polyurethane resin to the thermoplastic ether polyol polyurethane resin in the blended polymer is 10:90 to 50:50, and the thermoplastic ether polyol polyurethane resin includes a polyurethane resin A having flame resistance and a polyurethane resin B having lower flame resistance and higher adhesion properties than the polyurethane resin A.

The present invention also provides a protective layer-attached sealing resin sheet for a solar cell module, comprising a protective sheet and the above-described sealing resin sheet for the solar cell module of the invention, the sealing resin sheet being stacked on the protective sheet.

### Advantageous Effects of the Invention

The solar cell module of the present invention uses, as the first sealing resin layer and/or the second sealing resin layer, a sheet formed using the blended polymer of the thermoplastic polyester polyol polyurethane resin and the specific two types of thermoplastic ether polyol polyurethane resins at the predetermined blending ratio. Therefore, the solar cell module of the present invention can maintain its initial performance for a long period of time and has favorable sealing properties, adhesive strength, corrosion resistance, flame resistance, and water vapor permeation resistance. When the first sealing resin layer and the second sealing resin layer are formed of the same material, the solar cell module of the present invention can maintain its initial performance for a longer period of time and has higher flame resistance.

According to the production method of the present invention, the sealing resin sheet for the solar battery cell that is formed using the blended polymer of the thermoplastic polyester polyol polyurethane resin and the specific two types of thermoplastic ether polyol polyurethane resins at the predetermined blending ratio is used to form at least the first and/or second sealing resin layer through vacuum lamination treatment. Therefore, the solar cell module integrated at a time by the vacuum lamination treatment can be produced at high productivity.

### Brief Description of Drawings

FIG. 1 is a schematic cross-sectional view of a solar cell module of the present invention.
FIG. 2 is a schematic cross-sectional view of a vacuum laminator used to produce the solar cell module, with a flexible lid of the vacuum laminator removed from its main body.
FIG. 3 is a diagram illustrating vacuum lamination treatment performed in the vacuum laminator.

### Description of Embodiments

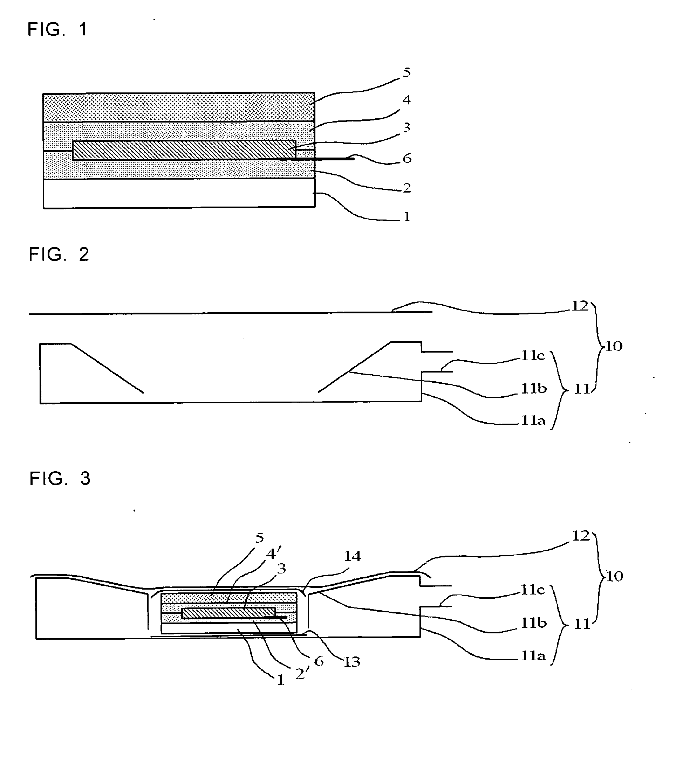

The solar cell module of the present invention will be described with reference to FIG. 1.

The solar cell module of the present invention has a structure in which a first sealing resin layer 2, a solar battery cell 3 to which a tab wire 6 used to provide electrical continuity with the outside of a vacuum laminator 10 is connected, a second sealing resin layer 4, and a protective sheet 5 are successively stacked on a module substrate 1, as shown in a schematic cross-sectional view (FIG. 1). The tab wire 6 is connected to a surface electrode of the solar battery cell 3 that is provided on its surface facing the module substrate 1 (i.e., a light-receiving surface). Preferably, the tab wire 6 is connected using a conductive adhesive (not shown), from the viewpoint of stress relaxation and an improvement in productivity. The above layered structure is basically the same as the structure of a conventional solar cell module.

The feature of the solar cell module of the present invention is that the first sealing resin layer 2 and/or the second sealing resin layer 4 is formed of a blended polymer of a thermoplastic polyurethane resin including an ester-based polyol unit (i.e., a thermoplastic ester polyol polyurethane resin) and a thermoplastic polyurethane resin including an ether-based polyol unit (i.e., a thermoplastic ether polyol polyurethane resin). The use of such a blended polymer allows favorable adhesive strength and hydrolysis resistance to be imparted to the first sealing resin layer 2 and/or the second sealing resin layer 4. In addition, flame resistance that meets UL Standard 94 can be imparted to the solar cell module. Preferably, at least the second sealing resin layer 4 is formed of the specific blended polymer. This is because moisture enters the solar cell module mainly from the protective sheet side.

Specific examples of the ester-based polyol unit include polyol units having an ester skeleton (-COO-).

Specific examples of the ether-based polyol unit include polyol units having a polyether chain (-CH₂CH₂O-) composed of polyethylene oxide.

The blending mass ratio of the thermoplastic ester polyol polyurethane resin to the thermoplastic ether polyol polyurethane resin is described. If the former is too small, the adhesive strength becomes low. If the former is too large, hydrolysis occurs easily, and corrosion of the surface electrode is more likely to occur. In addition, deterioration in adhesive strength is more likely to occur. Therefore, the blending mass ratio is 10:90 to 50:50 and preferably 30:70 to 50:50.

In the present invention, the thermoplastic ether polyol polyurethane resin includes a thermoplastic ether polyol polyurethane resin A having flame resistance (which may be referred simply to as a polyurethane resin A) and a thermoplastic ether polyol polyurethane resin B having lower flame resistance but having higher adhesion properties than the polyurethane resin A (which may be referred simply to as a polyurethane resin B). The use of such two different polyurethane resins can further improve the adhesive strength and flame resistance of the sealing resin.

Preferably, the level of the flame resistance of the polyurethane resin A meets UL standard 94. A resin with this level does not burn even when fire is brought close to the resin for 10 seconds. Examples of a method of imparting such flame resistance to the polyurethane resin A include addition of a well-known flame retardant, preferably a non-halogen-based flame retardant, to the polyurethane resin A. Specific examples of the non-halogen-based flame retardant include phosphorus, ammonium polyphosphate, and melamine cyanurate. When such a flame retardant is added, the adhesive strength tends to decrease. Therefore, preferably, the amount of the flame retardant added is determined in consideration of the balance between the flame resistance and adhesive strength.

The polyurethane resin B has lower flame resistance but higher adhesion properties than the polyurethane resin A. The adhesion properties of the polyurethane resin B are at the level in which the adhesive strength is preferably 20 N/cm or higher when a 180 degree peeling test is performed according to JIS-K6854-2 at a peeling rate of 50 mm/minute. The flame retardant may be added also to the polyurethane resin B so long as the initial adhesive strength is obtained.

The blending mass ratio of the polyurethane resin A to polyurethane resin B is described. If the former is too large (i.e., the latter is too small), the adhesive strength tends to decrease. If the former is too small (i.e., the latter is too large), the flame resistance tends to decrease. Therefore, the blending mass ratio is preferably 30:20 to 30:60 and more preferably 30:20 to 30:40.

The above-described blended polymer of the thermoplastic ester polyol polyurethane resin and the thermoplastic ether polyol polyurethane resin may optionally include an additional thermoplastic resin, a silane coupling agent, a cross-linking agent, an antioxidant, etc.

The thickness of the second sealing resin layer varies depending on the size of the solar battery cell 3 and is generally 0.1 to 0.6 mm and preferably 0.2 to 0.5 mm.

In the present invention, when the second sealing resin layer is formed of the above-described specific blended polymer, the first sealing resin layer may be formed of a conventional EVA resin but is preferably formed of the specific blended polymer, as is the second sealing resin layer. In such a case, higher adhesive strength and hydrolysis resistance can be imparted also to the first sealing resin layer 2. In addition, higher flame resistance that meets UL standard 94 can be imparted to the solar cell module. The thickness of the first sealing resin layer may be the same as the thickness of the second sealing resin layer.

Any of various well-known solar battery cells, protective sheets, tab wires, and conductive adhesives can be used as the solar battery cell 3, the protective sheet 5, the tab wire 6, and the conductive adhesive.

For example, the solar battery cell 3 used can be any of single crystalline silicon solar battery cells, polycrystalline solar battery cells, thin-film silicon solar battery cells, HIT solar battery cells, CIGS-based thin-film solar battery cells, etc. The protective sheet 5 used can be any of a sheet of a resin such as polyester, polyimide, or polyamide, a glass plate, etc. The tab wire 6 used can be, for example, a tab ribbon produced by plating a 150 µm-thick copper ribbon with solder to a thickness of 40 µm. The conductive adhesive used can be, for example, a thermosetting conductive adhesive prepared by dispersing conductive particles such as metal particles or metal-coated resin particles in a thermosetting binder resin conventionally used for connection of such a tab wire.

The blended polymer used to form the second sealing resin layer 4 or the first sealing resin layer 2 (i.e., the blend of the thermoplastic ester polyol polyurethane resin and the thermoplastic ether polyol polyurethane resin at a specific blending ratio) is formed into a sheet shape before use. Such a sheet is used as the sealing resin sheet for the solar cell module and serves as an embodiment of the present invention. Such a sealing resin sheet for the solar cell module can be produced by an extrusion molding method in which the molten blended polymer is extruded from an extrusion die into a sheet form. The sealing resin sheet can also be produced by a casting method in which a blended polymer coating solution diluted with an organic solvent such as toluene is applied to a release sheet using a well-known coating method and then the coating is dried. The thickness of the sealing resin sheet for the solar cell module can be appropriately selected according to the application purpose of the sealing resin sheet.

For the purpose of, for example, improving the productivity of the solar cell module, the second sealing resin layer 4 and the protective sheet 5 may be integrated in advance and used as a protective layer-attached sealing resin sheet. Such a sheet is used as the protective layer-attached sealing resin sheet for the solar cell module and also serves as an embodiment of the present invention. The integration can be performed using a well-known technique, and an extrusion molding method, a casting method, etc. can be used.

The solar battery module of the present invention can be produced using a well-known vacuum laminator. More specifically, the solar cell module of the present invention shown in FIG. 1 can be produced by placing, in the vacuum laminator, a stacked body produced by stacking the module substrate, the first sealing resin sheet, the solar battery cell with the tab wire connected or temporarily pasted thereto, the second sealing resin sheet, and the protective sheet and then integrating the stacked body at a time by vacuum lamination treatment. The solar battery cell with the tab wire connected thereto means that, for example, the tab wire has been firmly connected to the solar battery cell using solder or a conductive adhesive before the stacked body is placed in the vacuum laminator. The solar battery cell with the tab wire temporarily pasted thereto means that, for example, the tab wire has been pasted to the solar battery cell through the adhesion of a conductive adhesive to an extent such that the tab wire can be removed and re-pasted at room temperature. The tab wire and the conductive adhesive may be integrated in advance to form a reel-shaped stacked body.

An example of the vacuum laminator usable in the present invention will next be described. As shown in FIG. 2, the vacuum laminator 10 includes: a main body 11 that is made of a metal such as stainless steel and forms a lamination treatment space; and a flexible lid 12 such as a silicone rubber sheet that is placed on the main body 11 to seal the lamination treatment space. The main body 11 has inclined surfaces 11b formed inside the outer walls 11a of the main body 11. Under reduced pressure, the flexible lid 12 deforms along the inclined surfaces 11b. A decompression device of the main body 11 has an air outlet 11c, and the air outlet 11c is connected to a vacuum pump (not shown).

The vacuum lamination treatment will next be specifically described using FIG. 3.

First, a release sheet 13 is placed on the inner bottom of the main body 11 of the vacuum laminator 10. Then the module substrate 1, the first sealing resin sheet 2', the solar battery cell 3 with the tab wire connected or temporarily pasted to the surface electrode provided on the light-receiving surface thereof, the second sealing resin sheet 4', and the protective sheet 5 are aligned and stacked on the release sheet 13. Another release sheet 14 is placed on the stacked body, and the flexible lid 12 is placed thereon. In this case, the above-described protective layer-attached sealing resin sheet for the solar cell module may be used instead of the second sealing resin sheet 4' and the protective sheet 5.

Next, the vacuum laminator 10 is placed in a heating furnace (not shown), and the lamination treatment space is evacuated through the air outlet 11c while the vacuum laminator 10 is heated to the temperature at which the sealing resin softens or melts. The flexible lid 12 thereby presses the stacked body to perform the vacuum lamination treatment, and the solar cell module is obtained. During the vacuum lamination treatment, the temporarily pasted tab wire is firmly connected.

### Examples

The present invention will next be specifically described by way of Examples.

### Examples 1 to 6 and Comparative Examples 1 to 5

### (1) Production of sealing resin sheets

A thermoplastic ester polyol polyurethane resin (Elastollan ETHD95A, BASF Japan Ltd.), a flame resistant thermoplastic ether polyol polyurethane resin including a non-halogen-based flame retardant (polyurethane resin A: Elastollan 1175A-10W. BASF Japan Ltd.), a thermoplastic ether polyol polyurethane resin (polyurethane resin B: Elastollan ET-370, BASF Japan Ltd.) used as a hot-melt adhesive, an epoxy-based silane coupling agent (KBM-403, Shin-Etsu Chemical Co., Ltd.), and a hydrolysis stabilizer (KE9463, Rhein Chemie Japan) were dissolved and blended in tetrahydrofuran in each blending amount shown in TABLE 1, and sealing resin sheets having a thickness of 0.4 mm were produced by casting. In Comparative Example 5, EVA resin sheets having a thickness of 0.5 mm were used as the first and second sealing resin sheets.

### (2) Production of solar cell modules

A glass module substrate having a thickness of 3 mm was placed in a vacuum laminator (1016S, Nisshinbo Mechatronics Inc.). Then one of the sealing resin sheets produced in (1) above, a 180 µm-thick solar battery cell (polycrystalline Si Cell: IM12525, Motech) with a solder-coated copper tab wire temporarily pasted to an aluminum surface electrode on the light-receiving surface of the cell using an epoxy-based thermosetting conductive adhesive, a sealing resin sheet of the same type as the one of the sealing resin sheets produced in (1) above, and a polyester protective sheet (BS-SP, Toppan Printing Co., Ltd.) having a thickness of 230 µm were successively stacked on the glass module substrate. Vacuum lamination treatment was performed for 5 minutes in a heating furnace at 150°C such that a pressure of 0.1 MPa was applied to the stacked body, and a solar cell module was thereby produced.

### Example 7

### (a) Production of protective layer-attached sealing resin sheet

The same blended polymer as in Example 4 was extrusion-molded on a polyester protective sheet having an adhesive layer formed on one side (BS-SP, Toppan Printing Co., Ltd.) to produce a protective layer-attached sealing resin sheet.

### (b) Production of solar cell module

A solar cell module was produced as in Example 1 except that the protective layer-attached sealing resin sheet in (a) above was stacked on the solar battery cell instead of stacking the sealing resin sheet produced in (1) in Example 1 and the protective sheet on the solar battery cell.

### Example 8

A solar cell module was produced as in Example 1 except that the EVA resin sheet used in Comparative Example 1 was used instead of the first sealing resin sheet in Example 1.

### <Evaluation>

### (Sealing properties)

When the sealing resin sheets in Examples 1 to 6 and 8 and Comparative Examples 1 to 5 were produced, protective layer-attached sealing resin sheets were also produced by the same procedure as in Example 7. Separately, a straight tab wire having a thickness of 0.3 mm and a length of 100 mm was placed on super white glass of 50 mm x 100 mm so as to cross a short edge of the glass with one end of the tab wire located at the center of the super white glass. The protective layer-attached sealing resin sheet was placed on the tab wire, and vacuum lamination treatment was performed at 150°C for 5 minutes while a pressure of 100 KPa was applied from the protective layer side to thereby produce a sample for evaluating sealing properties. The tab wire was observed through the super white glass. When no air bubbles were found around the tab wire, the sample was rated "A." When air bubbles were found but were practically acceptable, the sample was rated "B." When air bubbles were found and were not practically acceptable, the sample was rated "C." The results obtained can be considered as the results of evaluation of the sealing properties of the sealing resin sheets in Examples 1 to 8 and Comparative Examples 1 to 5 and are shown in TABLE 1 as the evaluation results.

### (Adhesive strength)

Each of the solar cell modules obtained in Examples 1 to 8 and Comparative Example 1 to 5 was subjected to vacuum lamination and then maintained in an environment of a temperature of 85°C and a humidity of 85% for 1,000 hours. Then a 180 degree peeling test was performed at a peeling rate of 50 mm/minute according to JIS-K6854-2 to measure the adhesive strength to the glass module substrate. The results obtained are shown in TABLE 1. The adhesive strength is practically preferably 20 N/cm or higher.

### (Corrosion resistance)

Each of the solar cell modules obtained in Examples 1 to 8 and Comparative Examples 1 to 5 was maintained in an environment of a temperature of 85°C and a humidity of 85% for 1,000 hours and then visually observed under an optical microscope to determine whether or not corrosion (discoloration) occurred in the aluminum surface electrode of the solar cell module. The results obtained are shown in TABLE 1.

### (Flame resistance)

Each of the sealing resin sheets obtained in Examples 1 to 8 and Comparative Examples 1 to 5 was cut to a width of 13 mm and a length of 125 mm, and whether or not the cut piece burned under the condition that fire was brought close thereto for 10 seconds was determined according to UL standard 94. The results obtained are shown in TABLE 1.

### (Water vapor permeation resistance)

The water vapor permeability of each of the sealing resin sheets obtained in Examples 3 to 8 in an environment of 40°C and 90%Rh was measured according to JIS Z0208. The results obtained are shown in TABLE 1. The sealing resin sheet was rated "G (good)" when the water vapor permeability was less than 300 g/m²·day. The results obtained are shown in TABLE 1.

**[TABLE 1]**

| | Thermoplastic Ester Polyol Polyurethane Resin | Thermoplastic Ether Polyol Polyurethane Resin | | | Silane Coupling Agent | Hydrolysis Stabilizer | Sealing Properties | Adhesive Strength [N/cm] | Corrosion Resistance | Flame Resistance | Water Vapor Permeation Resistance |
|---|---|---|---|---|---|---|---|---|---|---|---|
| | | Polyurethane ResinA | Polyurethane Resin B | Polyurethane Resin A+ B | | | | | | | |
| Example 1 | 50 | 30 | 20 | 50 | 0.5 | - | A | 24 | No Corrosion | Not Burned | - |
| 2 | 50 | 30 | 20 | 50 | 0.5 | 1 | A | 41 | No Corrosion | Not Burned | - |
| 3 | 30 | 30 | 40 | 70 | 0.5 | - | A | 21 | No Conusion | Not Burned | G |
| 4 | 30 | 30 | 40 | 70 | 0.5 | 1 | A | 62 | No Corirosion | Not Burned | G |
| 5 | 10 | 30 | 60 | 90 | 0.5 | - | B | 42 | No Corrosion | Not Burned | G |
| 6 | 10 | 30 | 60 | 90 | 0.5 | 1 | B | 107 | No Corrosion | Not Burned | G |
| 7 | 30 | 30 | 40 | 70 | 0.5 | 1 | A | 62 | No Corrosion | Not Burned | G |
| 8 | 30 | 30 | 40 | 70 | 0.5 | 1 | A | 62 | No Corrosion | Not Burned | G |
| Comp. Ex.1 | 50 | - | 50 | 50 | 0.5 | - | A | 24 | No Cornosion | Burned | - |
| 2 | 30 | - | 70 | 70 | 0.5 | - | A | 21 | No Corrosion | Burned | - |
| 3 | 5 | 30 | 65 | 95 | 0.5 | - | B | 6 | No Corrosion | Not Burned | - |
| 4 | 60 | - | 40 | 40 | 0.5 | - | A | 1 | No Comosion | Burned | - |
| 5 | (EVA) | - | - | - | - | - | A | 15 | Corrosion | Burned | - |

In each of the solar cell modules in Examples 1 to 8, the blended polymer including ester polyol polyurethane and ether polyol polyurethane at a mass ratio of 1:1 to 9 is used as the sealing resin for the first and second sealing resin layers. In addition, the thermoplastic ether polyol polyurethane resin included in the blended polymer includes the polyurethane resin A having flame resistance and the polyurethane resin B having lower flame resistance but higher adhesion properties than the polyurethane resin A. As can be seen from TABLE 1, the solar cell modules in Examples 1 to 8 had high sealing properties. A reduction in their adhesive strength was suppressed even after the solar cell modules were maintained in an environment of a temperature of 85°C and a humidity of 85% for 1,000 hours, and no corrosion was found to occur. In addition, their flame resistance was favorable. The results also showed that the water vapor permeation resistance of each of the sealing resin sheets in Examples 3 to 8 was good. The water vapor permeation resistance evaluation test was not performed on the sealing resin sheets in Examples 1 and 2. However, it is expected that the results for these sealing resin sheets are similar to the results for the sealing resin sheet in Example 3.

The results for the solar cell module produced as in Example 4 except that the EVA resin layer was used as the sealing resin layer on the light-receiving surface side were also favorable. This shows that it is sufficient to use any of the specific blended polymers used in the present invention at least for the sealing resin layer on the protective sheet side.

In each of the solar cell modules in Comparative Examples 1 and 2, the polyurethane resin A having flame resistance was not used as a constituent component of the thermoplastic ether polyol polyurethane resin in the blended polymer used as the sealing resin. Therefore, these solar cell modules had a problem with flame resistance. In the solar cell module in Comparative Example 3 in which the mass ratio of the thermoplastic ester polyol polyurethane resin to the thermoplastic ether polyol polyurethane resin was less than 1/9, the adhesive strength of the sealing resin was not sufficient. The solar cell module in Comparative Example 5 in which EVA was used as the sealing resin had a problem with corrosion resistance and a problem with flame resistance.

### Industrial Applicability

The solar cell module of the present invention uses, as the sealing resin, a blended polymer of a thermoplastic ester polyol polyurethane resin and two specific types of thermoplastic ether polyol polyurethane resins at a predetermined blending ratio. The blended polymer used has favorable sealing properties, favorable adhesive strength, hydrolysis resistance (i.e., the property of substantially suppressing the corrosion of the electrode), favorable flame resistance, and water vapor permeation resistance. Therefore, the solar cell module of the present invention is useful because the solar cell module has high sealing properties and water vapor permeation resistance and can maintain its initial performance for a long period of time.

### Reference Signs List

| | |
|---|---|
| 1 | module substrate |
| 2 | first sealing resin layer |
| 2' | first sealing resin sheet |
| 3 | solar battery cell |
| 4 | second sealing resin layer |
| 4' | second sealing resin sheet |
| 5 | protective sheet |
| 6 | tab wire |
| 10 | vacuum laminator |
| 11 | main body |
| 11a | outer wall |
| 11b | inclined surface |
| 11c | air outlet |
| 12 | flexible lid |
| 13 | release sheet |
| 14 | another release sheet |

## Claims

1. A solar cell module comprising a module substrate, a first sealing resin layer, a solar battery cell with a tab wire connected thereto, a second sealing resin layer, and a protective sheet that are stacked one on top of another, wherein
the first sealing resin layer and/or the second sealing resin layer are/is formed of a blended polymer of a thermoplastic ester polyol polyurethane resin including an ester-based polyol unit and a thermoplastic ether polyol polyurethane resin including an ether-based polyol unit,
a blending mass ratio of the thermoplastic ester polyol polyurethane resin to the thermoplastic ether polyol polyurethane resin in the blended polymer is 10:90 to 50:50, and
the thermoplastic ether polyol polyurethane resin comprises a polyurethane resin A having flame resistance and a polyurethane resin B having lower flame resistance and higher adhesion properties than the polyurethane resin A.

2. The solar cell module according to claim 1, wherein a blending mass ratio of the polyurethane resin A to the polyurethane resin B is 30:20 to 30:60.

3. The solar cell module according to claim 1 or 2, wherein the polyurethane resin A includes a non-halogen-based flame retardant.

4. The solar cell module according to any of claims 1 to 3, wherein the second sealing resin layer and the protective sheet are a protective layer-attached sealing resin sheet integrated in advance.

5. The solar cell module according to any of claims 1 to 4, wherein the tab wire is connected to a surface electrode provided on a light-receiving surface of the solar battery cell with a conductive adhesive.

6. A method of producing a solar cell module, the method comprising: placing a stacked body in a vacuum laminator, the stacked body being prepared by stacking a module substrate, a first sealing resin sheet, a solar battery cell with a tab wire connected or temporarily pasted thereto, a second sealing resin sheet, and a protective sheet; and subjecting the stacked body to vacuum lamination treatment to integrate the stacked body at a time, wherein
a sealing resin sheet formed of a blended polymer of a thermoplastic ester polyol polyurethane resin including an ester-based polyol unit and a thermoplastic ether polyol polyurethane resin including an ether-based polyol unit is used as the first sealing resin sheet and/or the second sealing resin sheet, a blending mass ratio of the thermoplastic ester polyol polyurethane resin to the thermoplastic ether polyol polyurethane resin in the blended polymer is 10:90 to 50:50, and the thermoplastic ether polyol polyurethane resin includes a polyurethane resin A having flame resistance and a polyurethane resin B having lower flame resistance and higher adhesion properties than the polyurethane resin A.

7. The production method according to claim 6, wherein a protective layer-attached sealing resin sheet previously integrally formed is used as the second sealing resin sheet and the protective sheet.

8. A sealing resin sheet for a solar cell module, the sealing resin sheet formed of a blended polymer of a thermoplastic polyester polyol polyurethane resin including an ester-based polyol unit and a thermoplastic polyether polyol polyurethane resin including an ether-based polyol unit, wherein
a blending mass ratio of the thermoplastic ester polyol polyurethane resin to the thermoplastic ether polyol polyurethane resin in the blended polymer is 10:90 to 50:50, and the thermoplastic ether polyol polyurethane resin includes a polyurethane resin A having flame resistance and a polyurethane resin B having lower flame resistance and higher adhesion properties than the polyurethane resin A.

9. A protective layer-attached sealing resin sheet for a solar cell module, comprising a protective sheet and the sealing resin sheet for the solar cell module according to claim 8, the sealing resin sheet being stacked on the protective sheet.
